# EUROPEAN PATENT APPLICATION

(11) **EP 4 568 458 A1**
(43) Date of publication of application: **11.06.2025**
(21) Application number: 23863379.6
(22) Date of filing: 21.08.2023
(51) Int. Cl.: H10K 50/858, H10K 50/844, H10K 50/11, H10K 59/122, H10K 50/81, H10K 50/82, H10K 59/123, H10K 50/86, H10K 59/35, G09G 3/3233

(54) **DISPLAY PANEL COMPRISING LIGHT CONTROL MATERIAL, AND ELECTRONIC DEVICE**

(30) Priority: 08.09.2022 KR 20220114074; 12.10.2022 KR 20220130563
(71) Applicant: Samsung Electronics Co., Ltd., Suwon-si, Gyeonggi-do 16677 (KR)
(72) Inventor: LEE, Dongseop, Suwon-si Gyeonggi-do 16677 (KR); SHIN, Sungyoung, Suwon-si Gyeonggi-do 16677 (KR); YANG, Byungduk, Suwon-si Gyeonggi-do 16677 (KR); UHM, Minsuk, Suwon-si Gyeonggi-do 16677 (KR); KIM, Kwangtai, Suwon-si Gyeonggi-do 16677 (KR); YEOM, Donghyun, Suwon-si Gyeonggi-do 16677 (KR); LEE, Haechang, Suwon-si Gyeonggi-do 16677 (KR)
(74) Representative: Gulde & Partner
(86) International application number: PCT/KR2023/012349
(87) International publication number: WO 2024/053902

(57) **Abstract**

An electronic device is provided. The electronic device may comprise a display panel including a first set of pixels, each including first subpixels, and a second set of pixels, each including second subpixels, wherein the second set of pixels are between the first set of pixels. Each of the first subpixels may include a first light-emitting layer including a single light-emitting portion in order to provide a first viewing angle. Each of the first subpixels may include a first encapsulation layer on the first light-emitting layer. Each of the first subpixels may further include a light control material having a second refractive index different from the first refractive index of the first encapsulation layer.

## Description

### [Technical Field]

The following descriptions relate to a display panel including a light control material, and an electronic device.

### [Background Art]

An electronic device may display visual information via a display panel. For example, the visual information may be displayed via a plurality of pixels within the display panel. For example, each of the plurality of pixels may include at least one first sub pixel emitting light having a first color, at least one second sub pixel emitting light having a second color, and at least one third sub pixel emitting light having a third color.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device is provided. An electronic device may comprise a display panel including pixels of a first set, and pixels of a second set between the pixels of the first set, wherein each of the pixels of the first set includes first sub pixels, and each of the pixels of the second set of pixels includes second sub pixels. Each of the first sub pixels may include a first emitting layer including a single emitting portion for providing a first viewing angle. Each of the first sub pixels may include a first encapsulation layer on the first emitting layer. Each of the second sub pixels may include a second emitting layer including multiple emitting portions each having an area narrower than an area of the single emitting portion, for providing a second viewing angle narrower than the first viewing angle. Each of the second sub pixels may include a second encapsulation layer on the second emitting layer. The first encapsulation layer among the first encapsulation layer and the second encapsulation layer may include a groove, positioned on the single emitting portion, in a second surface opposite to a first surface contacted on the first emitting layer. Each of the first sub pixels may further include a light control material, filling the groove, having a second refractive index different from a first refractive index of the first encapsulation layer.

A display panel is provided. The display panel may include pixels of a first set, wherein each of the pixels of the first set includes first sub pixels. The display panel may include pixels of a second set between the pixels of the first set, wherein each of the pixels of the second set of pixels includes second sub pixels. Each of the first sub pixels may include a first emitting layer including a single emitting portion for providing a first viewing angle. Each of the first sub pixels may include a first encapsulation layer on the first emitting layer. Each of the second sub pixels may include a second emitting layer including multiple emitting portions each having an area narrower than an area of the single emitting portion, for providing a second viewing angle narrower than the first viewing angle. Each of the second sub pixels may include a second encapsulation layer on the second emitting layer. The first encapsulation layer among the first encapsulation layer and the second encapsulation layer may include a groove, positioned on the single emitting portion, in a second surface opposite to a first surface contacted on the first emitting layer. Each of the first sub pixels may further include a light control material, filling the groove, having a second refractive index different from a first refractive index of the first encapsulation layer.

### [Description of the Drawings]

FIG. 1 illustrates an example of a plurality of pixels in an exemplary display panel.
FIG. 2 illustrates an example of a light control material in each of first sub pixels in an exemplary display panel.
FIG. 3 illustrates an example of a structure of each of second sub pixels in an exemplary display panel.
FIG. 4 illustrates an example of a shape of a light control material when viewing each of first sub pixels in a direction opposite to a direction in which each of the first sub pixels faces.
FIG. 5 illustrates an example of a shape of a cross section of a light control material.
FIG. 6 illustrates a light control material 160 included as a single layer in first sub pixels 130.
FIG. 7 illustrates an example of a relative position between a light control material in a sub pixel in a center region of an exemplary display panel and a single emitting portion and a relative position between a light control material in a sub pixel in an edge region of the display panel and a single emitting portion.
FIG. 8 illustrates an example of distribution of light on each of first sub pixels.
FIG. 9 illustrates an example of visibility in a second mode provided via a display panel including pixels of a first set including first sub pixels each including a light control material.
FIG. 10A illustrates an example of pixels of a first set in an exemplary display panel.
FIG. 10B illustrates an example of each of first sub pixels including multiple emitting portions in an exemplary display panel.
FIG. 11 is a block diagram of an electronic device in a network environment according to various embodiments.
FIG. 12 is a block diagram of a display module according to various embodiments.

### [Mode for Invention]

An electronic device may display visual information via a display panel of the electronic device. The electronic device may provide one of a plurality of modes, including a first mode and a second mode, via the display panel. For example, the first mode may be referred to as a normal mode. For example, the second mode may indicate a mode that reduces light transmitted to a second space around a first space on the display panel relative to the first mode. For example, , since the second space corresponds to a space corresponding to a side of the display panel, unlike a user looking at the display panel from a front of the display panel in which the visual information corresponds to the first space of the display panel, it may be relatively difficult for a user looking at the display panel from the side of the display panel to identify the visual information in the second mode. For example, the second mode may indicate a mode reducing a probability that the visual information is exposed to the user looking at the display panel from the side of the display panel. For example, the second mode may be referred to as a private mode.

For example, the display panel may include pixels of a first set for a first viewing angle, and pixels of a second set between the pixels of the first set for a second viewing angle narrower than the first viewing angle, to provide the second mode. For example, in the second mode, at least a portion of the pixels of the first set may be emitted (or driven) to reduce a contrast ratio of visual information (or image) displayed using the pixels of the second set, while the pixels of the second set are emitted (or driven). For example, the at least a portion of the pixels of the first set may be emitted to reduce exposure of the visual information (or the image) to the side of the display panel. For example, when intensity of light provided through the emission of the at least a portion of the pixels of the first set is relatively strong, visibility of the visual information to the front of the display panel may be reduced. An electronic device and a display panel to be exemplified below may include a structure or material for controlling the emission of the at least a portion of the pixels of the first set, for the second mode.

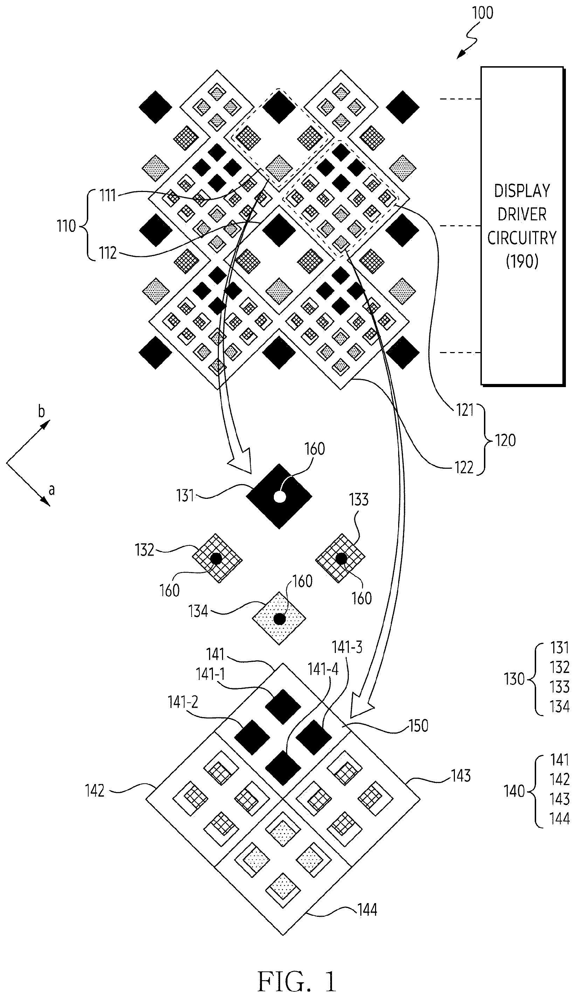

FIG. 1 illustrates an example of a plurality of pixels in an exemplary display panel.

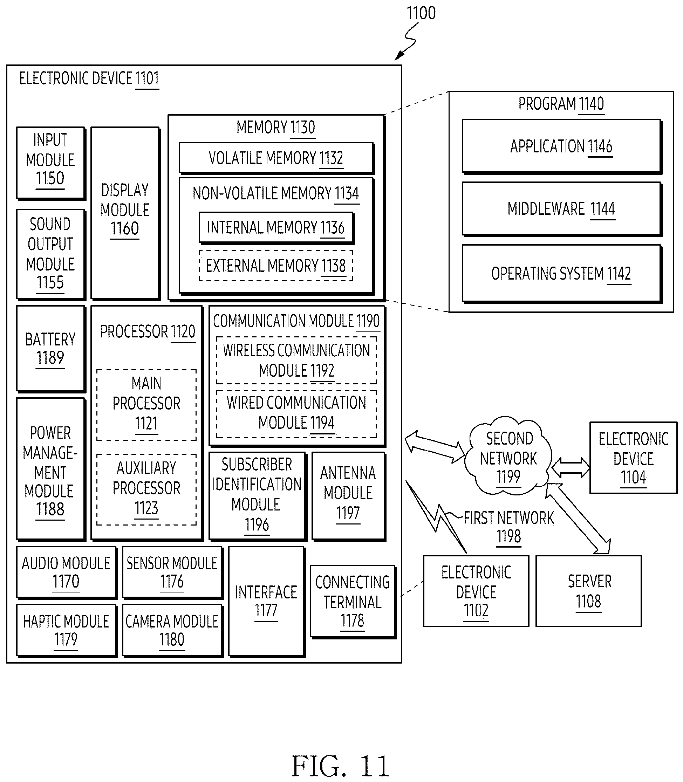

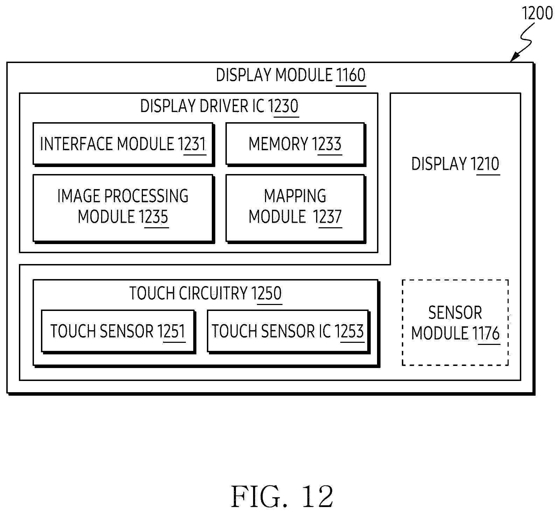

Referring to FIG. 1, a display panel 100 (e.g., at least a portion of a display module 1160 of FIG. 11, at least a portion of a display module 1160 of FIG. 12, and/or a display 1210 of FIG. 12) may be operatively coupled or connected to display driver circuitry 190 (e.g., at least another portion of the display module 1160 of FIG. 11 and/or the display driver IC 1230 of FIG. 12). The display panel 100 may be included in the electronic device 1101 of FIG. 11. However, it is not limited thereto.

The display panel 100 may include pixels of a first set 110. For example, the pixels of the first set 110 may include a pixel 111 and a pixel 112.

The display panel 100 may include pixels of a second set 120. For example, the pixels of the second set 120 may include a pixel 121 and a pixel 122.

The pixels of the first set 110 and the pixels of the second set 120 of the display panel 100 may be used to provide one of the plurality of modes including the first mode and the second mode. For example, each of first sub pixels 130 in each of the pixels of the first set 110 may include a structure for providing a first viewing angle. For example, each of the second sub pixels 140 in each of the pixels of the second set 120 may include a structure for providing a second viewing angle narrower than the first viewing angle. For example, the pixels of the first set 110 may be referred to as wide pixels in terms of providing the first viewing angle. For example, the pixels of the second set 120 may be referred to as narrow pixels in terms of providing the second viewing angle.

For example, the pixels of the second set 120 may be positioned between the pixels of the first set 110. For example, the pixels of the first set 110 and the pixels of the second set 120 may be alternately disposed. For example, the pixels in the first set 110 may be spaced apart from each other and arranged along first lines parallel to a first direction a and second lines parallel to a second direction b perpendicular to the first direction a. For example, in a space between the pixels of the first set 110, the pixels of the second set 120 may be arranged along third lines between the first lines parallel to the first direction a and fourth lines between the second lines parallel to the second direction b. However, it is not limited thereto. The pixels of the first set 110 and the pixels of the second set 120 may be arranged in various patterns. For example, the pixels of the first set 110 may be positioned on lines parallel to the first direction a, and the pixels of the second set 120 may be positioned between other lines between the lines.

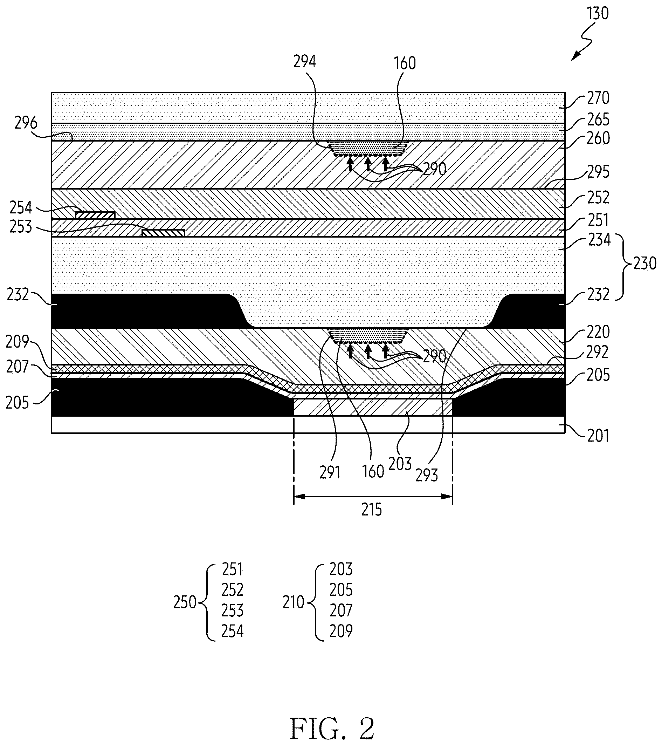

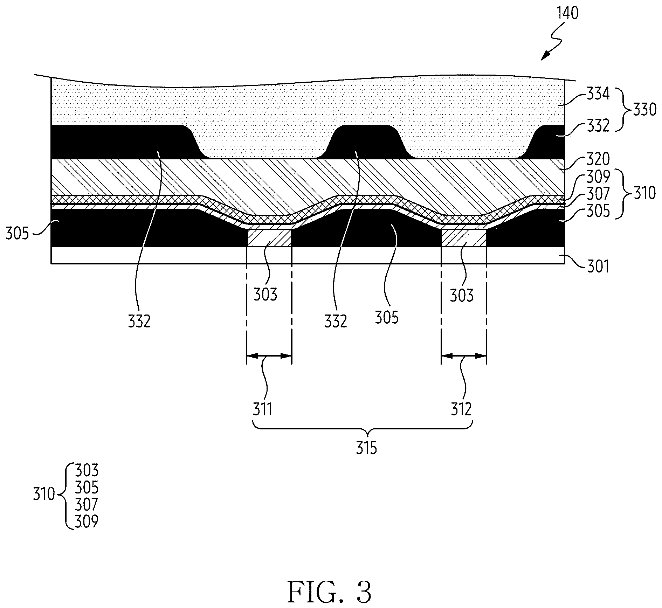

For example, each of the pixels of the first set 110 may include first sub pixels 130. For example, the first sub pixels 130 may emit light having a first color, light having a second color, and light having a third color. For example, sub pixel 131 may provide light having the first color (e.g., red). For example, each of sub pixel 132 and sub pixel 133 may provide light having the second color (e.g., green). For example, sub pixel 134 may provide light having the third color (e.g., blue). For example, the sub pixels 131, the sub pixels 132, the sub pixels 133, and the sub pixels 134 may be divided or distinguished from each other by a pixel definition layer (PDL) and/or a light blocking member (e.g., black matrix (BM)). The PDL and the light blocking member will be exemplified through FIGS. 2 and 3. For example, each of the first sub pixels 130 including the sub pixel 131, the sub pixel 132, the sub pixel 133, and the sub pixel 134 may include a single emitting portion defined by the PDL and/or the light blocking member. The single emitting portion will be exemplified through FIG. 2.

For example, each of the pixels of the second set 120 may include second sub pixels 140. For example, the second sub pixels 140 may emit light having the first color, light having the second color, and light having the third color. For example, sub pixel 141 may provide light having the first color (e.g., red). For example, each of sub pixel 142 and sub pixel 143 may provide light having the second color (e.g., green). For example, sub pixel 144 may provide light having the third color (e.g., blue). For example, the sub pixel 141, the sub pixel 142, the sub pixel 143, and the sub pixel 144 may be divided or distinguished from each other by a PDL and/or a light blocking member. The PDL will be exemplified through FIGS. 2 and 3. For example, the light blocking member may include a light blocking member 150. For example, each of the second sub pixels 140 including the sub pixel 141, the sub pixel 142, the sub pixel 143, and the sub pixel 144 may include multiple emitting portions (e.g., micropixels) defined by the PDL and the light blocking member. For example, the sub pixels 141 may include an emitting portion 141-1, an emitting portion 141-2, an emitting portion 141-3, and an emitting portion 141-4. For example, an area of each of the multiple emitting portions (e.g., the emitting portion 141-1, the emitting portion 141-2, the emitting portion 141-3, and the emitting portion 141-4) in each of the second sub pixels 140 may be narrower than an area of the single emitting portion in each of the first sub pixels 130. The multiple emitting portions will be exemplified through FIG. 3.

For example, the display driver circuitry 190 may control the display panel 100 to provide the second mode. For example, the display driver circuitry 190 may emit at least a portion of the pixels of the first set 110 and emit the pixels of the second set 120. For example, in the second mode, while the pixels of the second set 120 are emitted for displaying visual information (or image), the at least a portion of the pixels of the first set 110 may be emitted to reduce a contrast ratio of the visual information (or the image). For example, in the second mode, when light is emitted from the pixels of the second set 120 to express a first color (e.g., white), light emitted from each of the first sub pixels 130 may have a second color (e.g., black) different from the first color to reduce the contrast ratio of the visual information (or the image).

For example, the at least a portion of the pixels of the first set 110 may be emitted to reduce exposure of the visual information (or the image) relative to a side of the display panel 100. For example, the emission of the at least a portion of the pixels of the first set 110 in the second mode may reduce a quality when viewing the visual information (or the image) from a front of the display panel 100. For example, each of the first sub pixels 130 in each of the pixels of the first set 110 may include a light control material 160 to enhance the quality in the second mode. For example, the light control material (160) may be translucent.

For example, the light control material 160 may be included in the single emitting portion of each of the first sub pixels 130, when viewing each of the first sub pixels 130 in a direction opposite to a direction in which each of the first sub pixels 130 faces. The light control material 160 may be exemplified through FIG. 2.

FIG. 2 illustrates an example of a light control material in each of first sub pixels 130 in an exemplary display panel.

Referring to FIG. 2, each of the first sub pixels 130 may include a thin film transistor (TFT) 201, a first emitting layer 210, a first encapsulation layer 220, a functional layer 230, a layer 250 for a touch electrode, an organic insulating layer 260, and/or a transparent layer 270.

For example, the TFT 201 may include low temperature polycrystalline silicon (LTPS) or low temperature polycrystalline oxide (LTPO). For example, although not illustrated in FIG. 2, the TFT 201 may be disposed on a substrate, or disposed within the substrate. The substrate may include a bendable material such as polyimide (PI). However, it is not limited thereto. For example, the TFT 201 may be disposed below the first emitting layer 210. For example, the TFT 201 may include a switch electrically connected to an anode in a first electrode layer 203 in the first emitting layer 210.

For example, the first emitting layer 210 may include a first electrode layer 203, a PDL 205, an organic emitting layer 207, and a second electrode layer 209. For example, the first emitting layer 210 may include a single emitting portion 215.

For example, the first electrode layer 203 may be disposed on the TFT 201 in the substrate. For example, the first electrode layer 203 may include the anode printed in the first electrode layer 203.

For example, the PDL 205 may be disposed on the TFT 201. For example, the PDL 205 may be positioned along a boundary of the first electrode layer 203 to define the single emitting portion 215. For example, the PDL 205 may at least partially surround the first electrode layer 203. For example, the PDL 205 may be partially interposed between the TFT 201 and the organic emitting layer 207. For example, the PDL 205 may be disposed along a boundary of the single emitting portion 215.

Although FIG. 2 illustrates an example in which an organic emitting layer 207 (e.g., another portion of the organic emitting layer 207 to be exemplified below) is positioned on the PDL 205, the PDL 205 may be positioned on the TFT 201 and positioned along a boundary of each of the first electrode layer 203 and the organic emitting layer 207, unlike the illustration in FIG. 2.

For example, the organic emitting layer 207 may be disposed on the first electrode layer 203. For example, the organic emitting layer 207 may cover the anode printed in the first electrode layer 203. For example, a portion (e.g., the single emitting portion 215) of the organic emitting layer 207 may be contacted on the first electrode layer 203. For example, another portion of the organic emitting layer 207 may be positioned on the PDL 205. For example, the organic emitting layer 207 may be interposed between the first electrode layer 203 and the second electrode layer 209.

Although FIG. 2 illustrates an example in which the other portion of the organic emitting layer 207 is positioned on the PDL 205, the organic emitting layer 207 may include the portion of the organic emitting layer 207 without the other portion of the organic emitting layer 207, unlike the illustration in FIG. 2. For example, the organic emitting layer 207 may be positioned between the PDL 205.

For example, the second electrode layer 209 may be disposed on the organic emitting layer 207. For example, the second electrode layer 209 may include a cathode.

For example, the first encapsulation layer 220 may be disposed on the second electrode layer 209. For example, the first encapsulation layer 220 may cover the second electrode layer 209 to reduce the inflow of moisture or air into the display panel 100. For example, the first encapsulation layer 220 may include at least one inorganic layer and at least one organic layer. For example, the at least one inorganic layer and the at least one organic layer may be alternately stacked within the first encapsulation layer 220. For example, the first encapsulation layer 220 may be interposed between the first emitting layer 210 and the functional layer 230. For example, the first encapsulation layer 220 may include a light control material 160. The light control material 160 within the first encapsulation layer 220 will be exemplified below.

For example, the functional layer 230 may be disposed on the first encapsulation layer 220. For example, the functional layer 230 may include a polymer material. For example, the functional layer 230 may include a plurality of members. For example, the functional layer 230 may include a light blocking member 232 to define a single emitting portion 215. For example, the light blocking member 232 may be disposed along a boundary of the single emitting portion 215 when viewing the single emitting portion 215 in a direction opposite to a direction in which the single emitting portion 215 faces. However, it is not limited thereto. Although not illustrated in FIG. 2, the functional layer 230 may include a polarizing layer and/or a color filter layer. However, it is not limited thereto. For example, the functional layer 230 may include a compensation layer 234. For example, the compensation layer 234 may include an organic material. For example, the compensation layer may include a monomer.

For example, the layer 250 may be used to identify a touch input on the display panel 100. For example, the layer 250 may be disposed on the functional layer 230.

For example, the layer 250 may include an insulating layer 251 on which a conductive pattern 253 and a conductive pattern 254 are formed. For example, the conductive pattern 253 may be included in the insulating layer 251. For example, the conductive pattern 253 may be printed on the functional layer 230. For example, the conductive pattern 254 may be positioned on the insulating layer 251. For example, the conductive pattern 254 may be printed on the insulating layer 251. Although FIG. 2 illustrates an example in which the conductive pattern 253 and the conductive pattern 254 are positioned in different layers, this is for convenience of explanation. Unlike the illustration in FIG. 2, the conductive pattern 253 and the conductive pattern 254 may also be printed on a single layer.

For example, the layer 250 may include a protective layer 252 to protect the insulating layer 251. For example, the protective layer 252 may cover the conductive pattern 254 to protect the conductive pattern 254. For example, the protective layer 252 may be referred to as a passivation (PVX) layer. For example, the protective layer 252 may include a single film or multiple films formed of a silicon composite material as an insulating layer. However, it is not limited thereto.

For example, the organic insulating layer 260 may be disposed between the layer 250 and the transparent layer 270. For example, the organic insulating layer 260 may be disposed for a flat surface of the display panel 100. For example, the organic insulating layer 260 may be formed of multiple films of the monomer. For example, the organic insulating layer 260 may include a micro light control pattern (MLP) structure. For example, the organic insulating layer 260 may include a layer (or film) for controlling a path of light, having a certain transmittance and a certain thickness. For example, the layer may include an organic film and/or an inorganic film. The organic insulating layer 260 may be attached to the transparent layer 270. For example, the organic insulating layer 260 may be attached to the transparent layer 270 via an adhesive layer 265.

For example, the organic insulating layer 260 may include a light control material 160.

For example, the single emitting portion 215 may emit based on an electric field formed between the first electrode layer 203 and the second electrode layer 209 via the TFT 201 controlled by the display driver circuitry 190. For example, light 290 emitted from the single emitting portion 215 may be transmitted to the light control material 160. For example, the light control material 160 may be positioned on or within a path of the light 290. For example, the light control material 160 may have a second refractive index different from a first refractive index of the first encapsulation layer 220. For example, the light control material 160 may have a second refractive index lower than the first refractive index. For example, since the light control material 160 has the second refractive index lower than the first refractive index of the first encapsulation layer 220, the intensity (or amount) of light 290 transmitted outside the display panel 100 via the light control material 160 may be less than the intensity (or amount) of light 290 transmitted to the light control material 160. For example, the light control material 160 may reduce the intensity (or amount) of light 290 transmitted to a front of the display panel 100. For example, since light 290 is emitted from the single emitting portion 215 in the second mode to reduce a contrast ratio of an image displayed by the emission of the pixels of the second set 120, reducing of the intensity (or amount) of light 290 transmitted to the front of the display panel 100 via the light control material 160 may enhance visibility of the image. For example, the second refractive index may be higher than the first refractive index.

For example, the light control material 160 may be included in the first encapsulation layer 220. For example, an area of the light control material 160 may be narrower than an area of the single emitting portion 215, when viewing the single emitting portion 215 in a direction opposite to a direction in which the single emitting portion 215 faces. For example, the first encapsulation layer 220 may include a groove 291. For example, the groove 291 may be positioned on the single emitting portion 215. For example, the groove 291 may be positioned in a second surface 293 opposite a first surface 292 of the first encapsulation layer 220 contacted on the first emitting layer 210. For example, the second surface 293 may include a first portion including the groove 291 and a second portion surrounding the first portion. For example, the groove 291 may include at least a portion of the light control material 160. For example, the light control material 160 may fill the groove 291. For example, a first region on the first portion including the groove 291 including the light control material 160 may be darker than a second region on the second portion when the single emitting portion 215 is emitted. For example, the intensity (or amount) of light transmitted to the first region may be less than the intensity (or amount) of light transmitted to the second region.

For another example, the light control material 160 may be included within the organic insulating layer 260. For example, an area of the light control material 160 may be narrower than an area of the single emitting portion 215, when viewing the single emitting portion 215 in a direction opposite to a direction in which the single emitting portion 215 faces. For example, the organic insulating layer 260 may include a groove 294. For example, the groove 294 may be positioned on the single emitting portion 215. For example, the groove 294 may be positioned in a second surface 296 opposite a first surface 295 of the organic insulating layer 260 contacted on the layer 250. For example, the second surface 296 may include a first portion including the groove 294 and a second portion surrounding the first portion. For example, the groove 294 may include at least a portion of the light control material 160. For example, the light control material 160 may fill the groove 294. For example, a first region on the first portion including the groove 294 including the light control material 160 may be darker than a second region on the second portion when the single emitting portion 215 is emitted. For example, the intensity (or amount) of light transmitted to the first region may be less than the intensity (or amount) of light transmitted to the second region.

For another example, the light control material 160 may be included in each of the first encapsulation layer 220 and the organic insulating layer 260. For example, the light control material 160 may respectively fill the groove 291 of the first encapsulation layer 220 and the groove 294 of the organic insulating layer 260.

Although FIG. 2 illustrates an example in which the light control material 160 is included within the first encapsulation layer 220 and/or the organic insulating layer 260, the light control material 160 may also be included within another layer on the single emitting portion 215. For example, the light control material 160 may be included within a partial region of the functional layer 230 positioned on the single emitting portion 215. For example, the light control material 160 may be included within a partial region of the layer 250 positioned on the single emitting portion 215. For example, the light control material 160 may be included within a partial region of the adhesive layer 265 positioned on the single emitting portion 215. However, it is not limited thereto.

Referring back to FIG. 1, each of the second sub pixels 140 may include a structure for providing the second viewing angle narrower than the first viewing angle provided from the first sub pixels 130. The structure may be exemplified through FIG. 3.

FIG. 3 illustrates an example of a structure of each of second sub pixels 140 in an exemplary display panel.

Referring to FIG. 3, each of the second sub pixels 140 may include a TFT 301, a second emitting layer 310, a second encapsulation layer 320, and/or a functional layer 330. Although not illustrated in FIG. 3, each of the second sub pixels 140 may further include a layer for a touch electrode, an organic insulating layer, and/or a transparent layer, which are positioned on the functional layer 330.

For example, the TFT 301 may include LTPS or LTPO. For example, although not illustrated in FIG. 3, the TFT 301 may be disposed on or within a substrate. For example, the substrate may be substantially identical to the substrate exemplified in FIG. 2. However, it is not limited thereto. For example, the TFT 301 may be disposed below the second emitting layer 310. For example, the TFT 301 may include a switch electrically connected to an anode in a first electrode layer 303 in the second emitting layer 310.

For example, the second emitting layer 310 may include a first electrode layer 303, a PDL 305, an organic emitting layer 307, and a second electrode layer 309. For example, the second emitting layer 310 may include multiple emitting portions 315 including a first emitting portion 311 and a second emitting portion 312, unlike the first emitting layer 210 including a single emitting portion 215.

For example, the first electrode layer 303 may be disposed on the TFT 301 in the substrate. For example, the first electrode layer 303 may include the anode printed in the first electrode layer 303.

For example, the PDL 305 may be disposed on the TFT 301. For example, the PDL 305 may be positioned along a boundary of the first electrode layer 303 to define the multiple emitting portions 315. For example, the PDL 305 may at least partially surround the first electrode layer 303. For example, the PDL 305 may be partially interposed between the TFT 301 and the organic emitting layer 307. For example, the PDL 305 may be disposed along a boundary of the first emitting portion 311 and a boundary of the second emitting portion 312.

Although FIG. 3 illustrates an example in which an organic emitting layer 307 (e.g., another portion of the organic emitting layer 307 to be exemplified below) is positioned on the PDL 305, the PDL 305 may be disposed on the TFT 301, and positioned along a boundary of each of the first electrode layer 303 and the organic emitting layer 307, unlike the illustration in FIG. 3.

For example, the organic emitting layer 307 may be disposed on the first electrode layer 303. For example, the organic emitting layer 307 may cover the anode printed in the first electrode layer 303. For example, a portion (e.g., multiple emitting portions 315 including the first emitting portion 311 and the second emitting portion 312) of the organic emitting layer 307 may be contacted on the first electrode layer 303. For example, the other portion of the organic emitting layer 307 may be positioned on the PDL 305. For example, the organic emitting layer 307 may be interposed between the first electrode layer 303 and the second electrode layer 309.

Although FIG. 3 illustrates an example in which the other portion of the organic emitting layer 307 is positioned on the PDL 305, unlike the illustration of FIG. 3, the organic emitting layer 307 may include only the portion of the organic emitting layer 307 without the other portion of the organic emitting layer 307. For example, the organic emitting layer 307 may be positioned between the PDL 305.

For example, the second electrode layer 309 may be disposed on the organic emitting layer 307. For example, the second electrode layer 309 may include a cathode.

For example, the second encapsulation layer 320 may be disposed on the second electrode layer 309. For example, the second encapsulation layer 320 may cover the second electrode layer 309 to reduce the inflow of moisture or air into the display panel 100. For example, the second encapsulation layer 320 may include at least one inorganic layer and at least one organic layer. For example, the at least one inorganic layer and the at least one organic layer may be alternately stacked within the second encapsulation layer 320. For example, the second encapsulation layer 320 may be interposed between the second emitting layer 310 and the functional layer 330. For example, the second encapsulation layer 320 may not include the light control material 160, unlike the first encapsulation layer 220. For example, the second encapsulation layer 320 may not include a groove, unlike the first encapsulation layer 220 including a groove 291. For example, since each of the second sub pixels 140 may be emitted for displaying an image in the second mode, unlike each of the first sub pixels 130 for reducing a contrast ratio in the second mode, each of the second sub pixels 140 may not include a groove and a light control material 160 filling the groove.

For example, the functional layer 330 may be disposed on the second encapsulation layer 320. For example, the functional layer 330 may include a polymer material. For example, the functional layer 330 may include a plurality of members. For example, the functional layer 330 may include a light blocking member 332 for defining the multiple emitting portions 315. For example, the light blocking member 332 may be disposed along a boundary of each of the multiple emitting portions 315, when viewing the multiple emitting portions 315 in a direction opposite to a direction in which each of the multiple emitting portions 315 faces. However, it is not limited thereto. Although not illustrated in FIG. 3, the functional layer 330 may include a polarizing layer and/or a color filter layer. However, it is not limited thereto. For example, the functional layer 330 may include a compensation layer 334. For example, the compensation layer 334 may include an organic material. For example, the compensation layer may include a monomer.

Although not illustrated in FIG. 3, each of the second sub pixels 140 may further include a layer for a touch electrode, an organic insulating layer, and/or a transparent layer, like each of the first sub pixels 130. For example, each of the layer for the touch electrode and the transparent layer in each of the second sub pixels 140 may correspond to each of the layer 250 and the transparent layer 270 in each of the first sub pixels 130.

For example, the organic insulating layer (not illustrated) within the second sub pixels 140 may further include a light blocking member, unlike the organic insulating layer 260. For example, the light blocking member may be included to define the multiple emitting portions 315. For example, the light blocking member may be disposed along a boundary of each of the multiple emitting portions 315, when viewing the multiple emitting portions 315 in a direction opposite to a direction in which the multiple emitting portions 315 face.

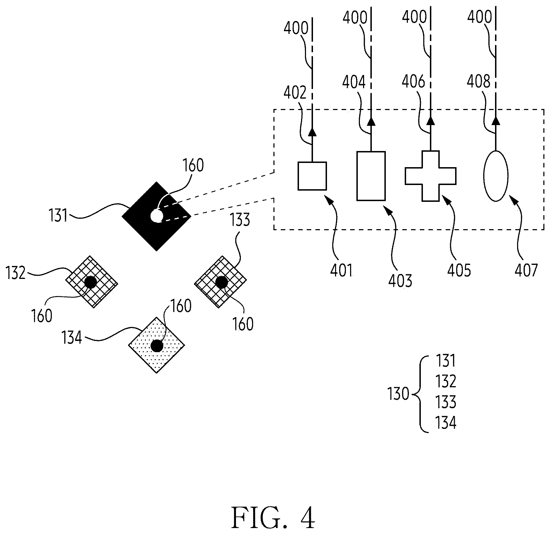

Referring back to FIG. 1, a shape of the light control material 160 within the first sub pixels 130 when viewing the first sub pixels 130 in a direction opposite to a direction in which the first sub pixels 130 faces may be a circle. For example, the shape of the light control material 160 may be replaced with another shape. The other shape of the light control material 160 may be exemplified through FIG. 4.

FIG. 4 illustrates an example of a shape of a light control material 160 when viewing each of first sub pixels 130 in a direction opposite to a direction in which each of the first sub pixels 130 faces.

Referring to FIG. 4, when viewing each of the first sub pixels 130 in a direction opposite to a direction in which each of the first sub pixels 130 faces, the light control material 160 may have another shape distinct from a circle.

For example, the shape of the light control material 160 when viewing each of the first sub pixels 130 in a direction opposite to a direction in which each of the first sub pixels 130 faces may be a square, like a shape 401. For example, an orientation of the light control material 160 having the shape 401 may be implemented in various ways according to the design. Although FIG. 4 illustrates an example in which an angle between a direction 402 indicating the orientation of the light control material 160 and a reference line 400 is 0 degrees, the angle between the direction 402 and the reference line 400 may be implemented as one angle within a range greater than 0 degrees and less than 360 degrees.

For another example, the shape of the light control material 160 when viewing each of the first sub pixels 130 in a direction opposite to a direction in which each of the first sub pixels 130 faces may be a rectangle, like a shape 403. For example, an orientation of the light control material 160 having the shape 403 may be implemented in various ways according to the design. Although FIG. 4 illustrates an example in which an angle between a direction 404 indicating the orientation of the light control material 160 and the reference line 400 is 0 degrees, the angle between the direction 404 and the reference line 400 may be implemented as one angle within a range greater than 0 degrees and less than 360 degrees.

For still another example, the shape of the light control material 160 when viewing each of the first sub pixels 130 in a direction opposite to a direction in which each of the first sub pixels 130 faces may be a cross shape, like a shape 405. For example, an orientation of the light control material 160 having the shape 405 may be implemented in various ways according to the design. Although FIG. 4 illustrates an example in which an angle between a direction 406 indicating the orientation of the light control material 160 and the reference line 400 is 0 degrees, the angle between the direction 406 and the reference line 400 may be implemented as one angle within a range greater than 0 degrees and less than 360 degrees.

For still another example, the shape of the light control material 160 when viewing each of the first sub pixels 130 in a direction opposite to a direction in which each of the first sub pixels 130 faces may be an elliptical shape, like a shape 407. For example, an orientation of the light control material 160 having the shape 407 may be implemented in various ways according to the design. Although FIG. 4 illustrates an example in which an angle between a direction 408 indicating the orientation of the light control material 160 and the reference line 400 is 0 degrees, the angle between the direction 408 and the reference line 400 may be implemented as one angle within a range greater than 0 degrees and less than 360 degrees.

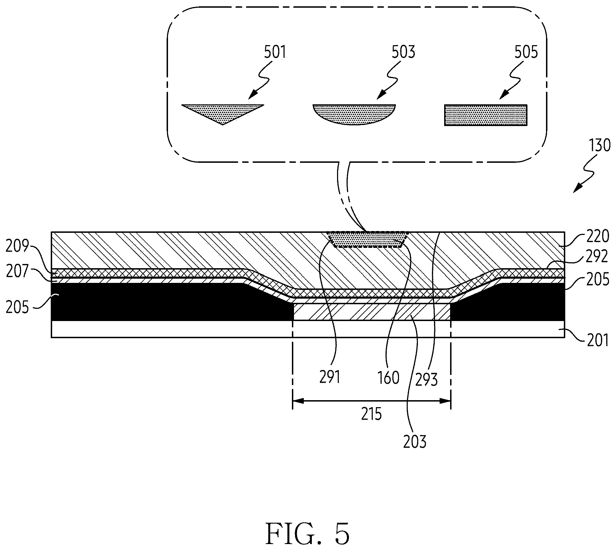

Referring back to FIG. 1, the light control material 160 may include a surface having a convex shape toward the single emitting portion (e.g., the single emitting portion 215 of FIG. 2) to reduce the intensity of light passing through the light control material 160 or to refract some of the light in a different direction. For example, as shown in FIG. 2, a cross section of the light control material 160 may be a trapezoid (or an equilateral trapezoid). For example, a shape of the cross section of the light control material 160 may be replaced with another shape distinct from the trapezoid. The other shape of the cross section of the light control material 160 may be exemplified through FIG. 5.

FIG. 5 illustrates an example of a shape of a cross section of a light control material.

Referring to FIG. 5, a shape of a cross-section of a light control material 160 may have a different shape distinct from a trapezoid.

For example, the shape of the cross-section of the light control material 160 may be a triangle, like a shape 501. For example, the shape of the cross section of the light control material 160 may be a semicircle, like a shape 503. For example, according to the second refractive index of the light control material 160, the cross section of the light control material 160 may have another shape distinct from a convex shape toward the single emitting portion 215. For example, the shape of the cross section of the light control material 160 may be a rectangle, like a shape 505. However, it is not limited thereto.

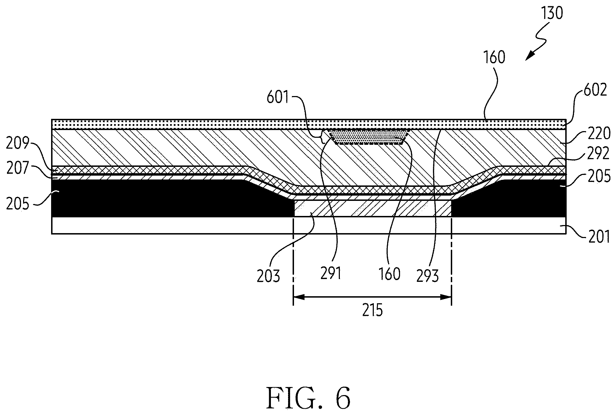

Referring back to FIG. 1, the light control material 160 may be included in each of first sub pixels 130 as a single layer protruding toward a layer within the first sub pixels 130. The single layer may be exemplified through FIG. 6.

FIG. 6 illustrates a light control material 160 included as a single layer in first sub pixels 130.

Referring to FIG. 6, the light control material 160 may be included in each of the first sub pixels 130 as a layer 602 including a protrusion portion 601 filling a groove 291 of a first encapsulation layer 220. For example, when the layer 602 is included in each of the first sub pixels 130, the protrusion portion 601 in the layer 602 may be used to enhance visibility of an image provided in the second mode. For example, when the layer 602 is included in each of the first sub pixels 130, the light control material 160 may be implemented as a material attachable to a functional layer 230. However, it is not limited thereto.

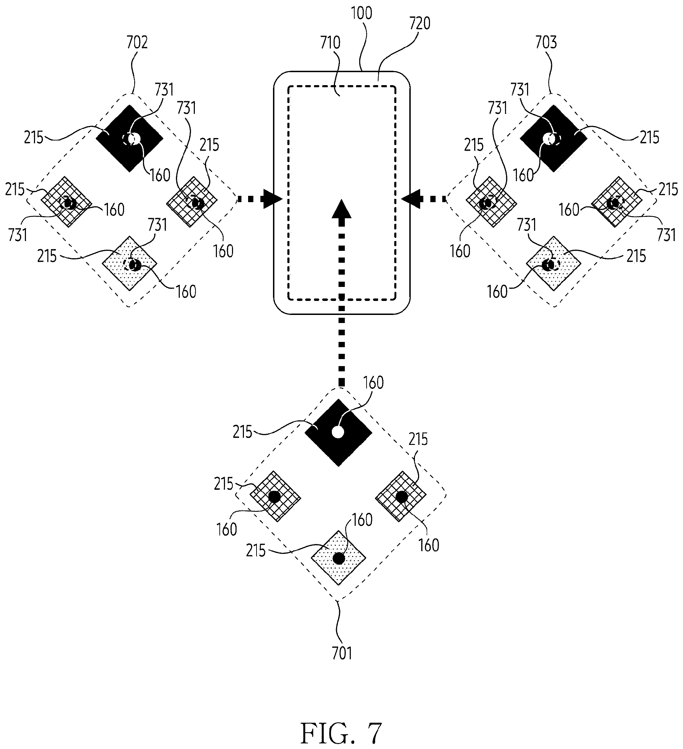

Referring back to FIG. 1, a relative position relationship between the light control material 160 and the single emitting portion (e.g., the single emitting portion 215 of FIG. 2) may be different according to positions of the pixels of the first set 110. For example, a display panel 100 may include a center region and an edge region surrounding the center region. For example, a relative position between the light control material 160 in a sub pixel of a pixel in the center region among the pixels of the first set 110 and the single emitting portion may be different from a relative position between the light control material 160 in a sub pixel of a pixel in the edge region among the pixels of the first set 110 and the single emitting portion. The relative position between the light control material 160 in the sub pixel of the pixel in the center region and the single emitting portion and the relative position between the light control material 160 in the sub pixel of the pixel in the edge region and the single emitting portion may be exemplified through FIG. 7.

FIG. 7 illustrates an example of a relative position between a light control material in a sub pixel in a center region of an exemplary display panel and a single emitting portion and a relative position between a light control material in a sub pixel in an edge region of the display panel and a single emitting portion.

Referring to FIG. 7, a display panel 100 may include a center region 710 and an edge region 720 extending from the center region 710. For example, the edge region 720 may surround the center region 710. For example, the edge region 720 may be disposed along edges of the display panel 100.

For example, each of first sub pixels 130 in a pixel 701 positioned within the center region 710 among the pixels of the first set 110 may include a light control material 160. For example, the light control material 160 in each of the first sub pixels 130 in the pixel 701 may be positioned in a center of a single emitting portion 215, when viewing each of the first sub pixels 130 in the pixel 701 in a direction opposite to a direction in which each of the first sub pixels 130 in the pixel 701 faces.

For example, each of first sub pixels 130 in a pixel 702 positioned within the edge region 720 among the pixels of the first set 110 may include the light control material 160. For example, the light control material 160 in each of first sub pixels 130 in the pixel 702 may be positioned to the right of a position 731 corresponding to a position of the light control material 160 in each of the first sub pixels 130 in the pixel 701. For example, since the pixel 702 in the edge region 720 is positioned to the left of the center region 710 and the light control material 160 is included in each of the pixels of the first set 110 to enhance visibility from a front of the display panel 100, the light control material 160 in each of the first sub pixels 130 in the pixel 702 may be positioned to the right of the position 731.

For example, each of first sub pixels 130 in a pixel 703 positioned within the edge region 720 among the pixels of the first set 110 may include the light control material 160. For example, the light control material 160 in each of the first sub pixels 130 in the pixel 703 may be positioned to the left of the position 731 corresponding to the position of the light control material 160 in each of the first sub pixels 130 in the pixel 701. For example, since the pixel 703 in the edge region 720 is positioned to the right of the center region 710 and the light control material 160 is included in each of the pixels of the first set 110 to enhance visibility from the front of the display panel 100, the light control material 160 in each of the first sub pixels 130 in the pixel 703 may be positioned to the left of the position 731.

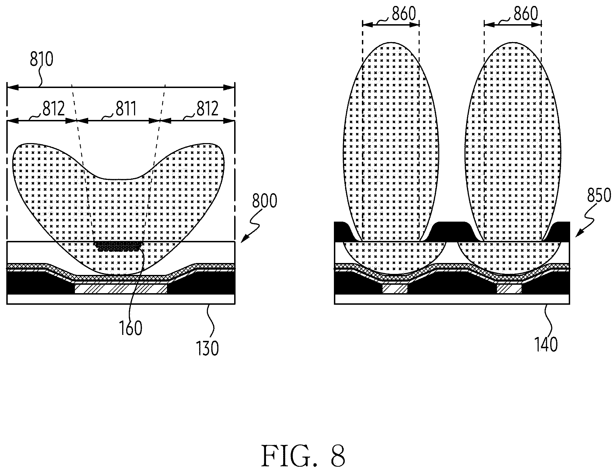

Referring back to FIG. 1, since each of the first sub pixels 130 in each of the pixels of the first set 110 includes the light control material 160, the intensity (or amount) of light transmitted to a first region on the light control material 160 in each of the first sub pixels 130 in the second mode may be less than the intensity (or amount) of light transmitted to a second region on each of the first sub pixels 130 surrounding the first region in the second mode. A difference between the intensity of light transmitted to the first region and the intensity of light transmitted to the second region may be exemplified through FIG. 8.

FIG. 8 illustrates an example of distribution of light on each of first sub pixels.

Referring to FIG. 8, in the second mode, distribution of light emitted from a single emitting portion 215 within each of first sub pixels 130 may be represented as a state 800. For example, a region 810 on the first sub pixels 130 may include a first region 811 defined on a light control material 160 and a second region 812 surrounding the first region 811. For example, as represented via the state 800, the intensity of the light transmitted to the first region 811 may be less than the intensity of the light transmitted to the second region 812.

For example, in the second mode, while each of the first sub pixels 130 is emitted (or driven) to reduce a contrast ratio, each of second sub pixels 140 may be emitted for displaying visual information, like a state 850. For example, like the state 850, light emitted from multiple emitting portions 315 in each of the second sub pixels 140 may be focused within a region 860 on the multiple emitting portions 315 by a PDL 305 and/or a light blocking member 332. For example, since the light represented as in the state 850 is emitted for the displaying of the visual information, the intensity of the light represented as in the state 850 may be greater than the intensity of the light represented as in the state 800.

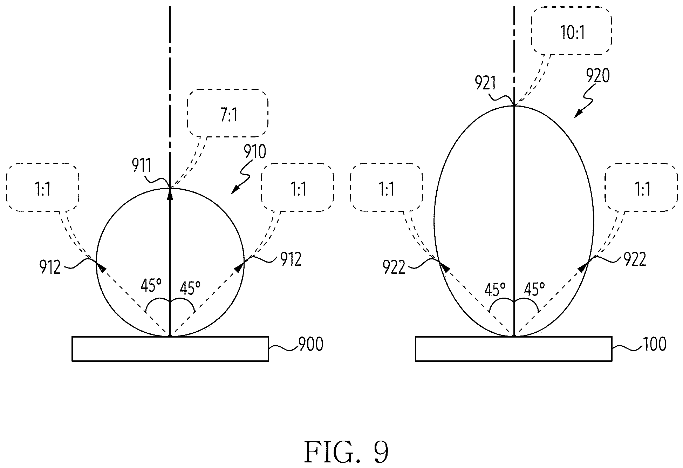

For example, since the display panel 100 includes of the pixels of the first set 110 including first sub pixels 130 each including the light control material 160, the display panel 100 providing the second mode may provide enhanced visibility, compared to visibility in the second mode provided by another display panel including pixels of a first set including first sub pixels, wherein each of the first sub pixels does not include the light control material 160. The enhanced visibility may be exemplified through FIG. 9.

FIG. 9 illustrates an example of visibility in a second mode provided via a display panel including pixels of a first set including first sub pixels each including a light control material.

Referring to FIG. 9, a display panel 900 may include pixels of a first set each including sub pixels, wherein the sub pixels do not include a light control material 160. For example, in the second mode, the display panel 900 may provide a contrast ratio of 7:1 at a position 911 representing a front of the display panel 900, and a contrast ratio of 1:1 at each of positions 912 representing a side of the display panel 900, like a state 910.

For example, since the display panel 100 includes a light control material 160 in each of first sub pixels 130 within each of the pixels of the first set 110, the display panel 100 may provide a contrast ratio of 10:1 at a position 921 representing the front of the display panel 100 and a contrast ratio of 1:1 at each of positions 922 representing the side of the display panel 100 in the second mode, like a state 920. For example, since the display panel 100 includes the light control material 160 in each of the first sub pixels 130 in each of the pixels of the first set 110, the display panel 100 may provide a higher contrast ratio relative to the front of the display panel 100 within the second mode than the display panel 900. For example, while providing the second mode, the display panel 100 may provide enhanced visibility as well as protect user privacy.

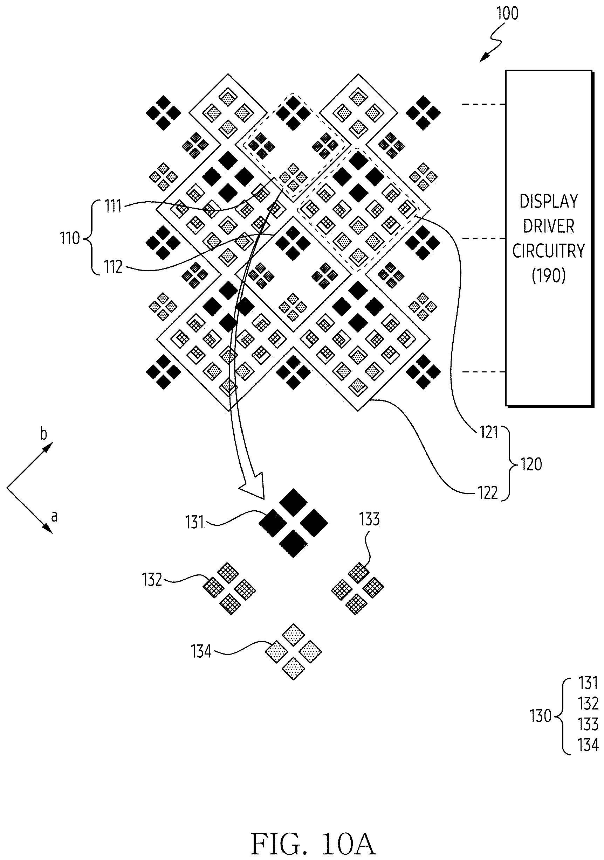

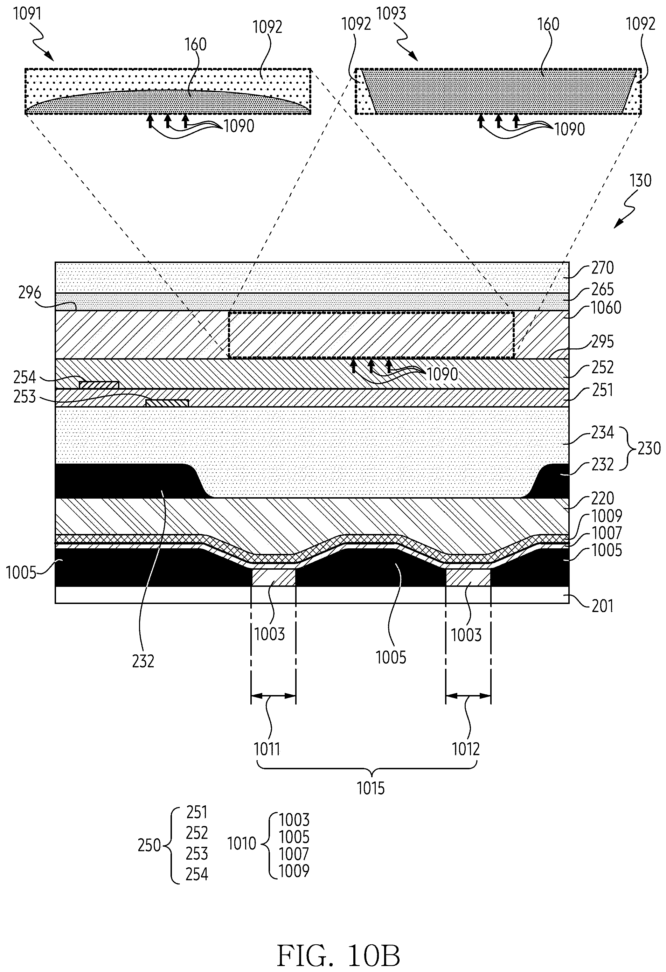

The above descriptions exemplify that each of first sub pixels 130 included in each of the pixels of the first set 110 includes a single emitting portion 215, but each of the first sub pixels 130 included in the pixels of the first set 110 may also include multiple emitting portions, like each of second sub pixels 140 included in each of the pixels of the second set 120. Each of sub pixels 130 including the multiple emitting portions may be exemplified through descriptions of FIGS. 10A and 10B.

FIG. 10A illustrates an example of pixels of a first set 110 in an exemplary display panel 100.

Referring to FIG. 10A, each of first sub pixels 130 included in each of the pixels of the first set 110 may include multiple emitting portions, unlike each of the first sub pixels 130 illustrated through FIGS. 1, 2, 4, 5, 6, 7, and 8. The multiple emitting portions may be exemplified through FIG. 10B.

FIG. 10B illustrates an example of each of first sub pixels 130 including multiple emitting portions in an exemplary display panel.

Referring to FIG. 10B, each of the first sub pixels 130 may include a TFT 201, a first emitting layer 1010, a first encapsulation layer 220, a functional layer 230, a layer 250 for a touch electrode, an organic insulating layer 1060, and/or a transparent layer 270.

For example, the TFT 201 may include LTPS or LTPO. For example, the TFT 201 may include a switch electrically connected to an anode in the first electrode layer 1003.

For example, the first emitting layer 1010 may include a first electrode layer 1003, a PDL 1005, an organic emitting layer 1007, and a second electrode layer 1009. For example, the first emitting layer 1010 may include multiple emitting portions 1015 including a first emitting portion 1011 and a second emitting portion 1022, unlike a first emitting layer 210 including a single emitting portion 215.

For example, the first electrode layer 1003 may be disposed on the TFT 1001. For example, the first electrode layer 1003 may include the anode printed in the first electrode layer 1003.

For example, the PDL 1005 may be positioned on the TFT 201. For example, the PDL 1005 may be positioned along a boundary of the first electrode layer 1003 to define the multiple emitting portions 1015. For example, the PDL 1005 may at least partially surround the first electrode layer 1003. For example, the PDL 1005 may be partially interposed between the TFT 201 and the organic emitting layer 1007. For example, the PDL 1005 may be disposed along a boundary of a first emitting portion 1011 and a boundary of the second emitting portion 1012.

Although FIG. 10B illustrates an example in which the organic emitting layer 1007 (e.g., another portion of the organic emitting layer 1007 to be exemplified below) is positioned on the PDL 1005, the PDL 1005 may be disposed on the TFT 201 and positioned along a boundary of each of the first electrode layer 1003 and the organic emitting layer 1007, unlike the illustration in FIG. 10B.

For example, the organic emitting layer 1007 may be disposed on the first electrode layer 1003. For example, the organic emitting layer 1007 may cover the anode printed in the first electrode layer 1003. For example, a portion (e.g., the multiple emitting portions 1015 including the first emitting portion 1011 and the second emitting portion 1012) of the organic emitting layer 1007 may be contacted on the first electrode layer 1003. For example, the other portion of the organic emitting layer 1007 may be positioned on the PDL 1005. For example, the organic emitting layer 1007 may be interposed between the first electrode layer 1003 and the second electrode layer 1009.

Although FIG. 10B illustrates an example in which the other portion of the organic emitting layer 1007 is positioned on the PDL 1005, the organic emitting layer 1007 may also include only the portion of the organic emitting layer 1007 without the other portion of the organic emitting layer 1007, unlike the illustration in FIG. 10B. For example, the organic emitting layer 1007 may be positioned between the PDL 1005.

For example, the second electrode layer 1009 may be disposed on the organic emitting layer 1007. For example, the second electrode layer 1009 may include a cathode.

For example, the first encapsulation layer 220 may be disposed on the second electrode layer 1009. For example, the first encapsulation layer 220 may cover the second electrode layer 1009 to reduce the inflow of moisture or air into the display panel 100. For example, the first encapsulation layer 220 may include at least one inorganic layer and at least one organic layer. For example, the at least one inorganic layer and the at least one organic layer may be alternately stacked within the first encapsulation layer 220. For example, the first encapsulation layer 220 may be interposed between the first emitting layer 1010 and the functional layer 230.

For example, the functional layer 230 may be disposed on the first encapsulation layer 220. For example, the functional layer 230 may include a polymer material. For example, the functional layer 230 may include a plurality of members. For example, the functional layer 230 may include a light blocking member 232 to define each of the multiple emitting portions 1015 or to define a boundary of a region including the multiple emitting portions 1015. However, it is not limited thereto. Although not illustrated in FIG. 10B, the functional layer 230 may include a polarizing layer and/or a color filter layer. However, it is not limited thereto. For example, the functional layer 230 may include a compensation layer 234. For example, the compensation layer 234 may include an organic material. For example, the compensation layer may include a monomer.

For example, the layer 250 may be used to identify a touch input on the display panel 100. For example, the layer 250 may be disposed on the functional layer 230.

For example, the layer 250 may include an insulating layer 251 on which a conductive pattern 253 and a conductive pattern 254 are formed. For example, the conductive pattern 253 may be included in the insulating layer 251. For example, the conductive pattern 253 may be printed on the functional layer 230. For example, the conductive pattern 254 may be positioned on the insulating layer 251. For example, the conductive pattern 254 may be printed on the insulating layer 251. Although FIG. 10B illustrates an example in which the conductive pattern 253 and the conductive pattern 254 are positioned in different layers, this is for convenience of explanation. Unlike the illustration in FIG. 10B, the conductive pattern 253 and the conductive pattern 254 may be printed on a single layer.

For example, the layer 250 (e.g., the layer for a touch electrode) may include a protective layer 252 for protecting the insulating layer 251 including the conductive pattern 253. For example, the protective layer 252 may cover the conductive pattern 254 to protect the conductive pattern 254. For example, the protective layer 252 may be referred to as a passivation (PVX) layer. For example, the protective layer 252 may include a single film or multiple films formed of a silicon composite material as an insulating layer. However, it is not limited thereto.

For example, the organic insulating layer 1060 may be disposed between the layer 250 and the transparent layer 270. For example, the organic insulating layer 1060 may be disposed for a flat surface of the display panel 100. For example, the organic insulating layer 1060 may be formed of multiple films of the monomer. For example, the organic insulating layer 1060 may include a micro light control pattern (MLP) structure. For example, the organic insulating layer 1060 may include a layer (or film) for controlling a path of light, having a certain transmittance and a certain thickness. For example, the layer may include an organic film and/or an inorganic film. The organic insulating layer 1060 may be attached to the transparent layer 270. For example, the organic insulating layer 260 may be attached to the transparent layer 270 via an adhesive layer 265.

For example, the organic insulating layer 1060 may include a light control material 160.

For example, the organic insulating layer 1060 may include the light control material 160 positioned on the protective layer 252, and another material 1092 positioned on the light control material 160, like a state 1091. For example, the light control material 160 may be positioned on or within a path of light 1090 emitted from the multiple emitting portions 1015. For example, a refractive index of the light control material 160 may be different from a refractive index of the other material 1092. For example, the refractive index of the light control material 160 may be higher than the refractive index of the other material 1092. Although not illustrated in FIG. 10B, each of second sub pixels 140 may include an organic insulating layer including and the other material 1092 among the light control material 160 and the other material 1092, unlike each of the first sub pixels 130 including the multiple emitting portions 1015. For example, each of the second sub pixels 140 may not include the light control material 160.

For example, the organic insulating layer 1060 may include only the light control material 160 positioned on the protective layer 252 on a path of light 1090 or within the path of the light 1090, like a state 1093. In the state 1093, the light control material 160 may be surrounded by another material 1092 when viewing each of the first sub pixels 130 in a direction opposite to a direction of the light 1090. For example, a refractive index of the light control material 160 may be different from a refractive index of the other material 1092. For example, the refractive index of the light control material 160 may be higher than the refractive index of the other material 1092. For example, the organic insulating layer 1060 may include an opening (or groove) extending from a first surface of the organic insulating layer 1060 contacted on the layer 250 to a second surface of the organic insulating layer 1060 contacted on the adhesive layer 265 (or opposite the first surface of the organic insulating layer 1060). For example, the light control material 160 may fill at least a portion of the opening (or the groove). For example, a first region on the opening (or the groove) of the organic insulating layer 1060 including the light control material 160 may be darker than a second region on a portion of the organic insulating layer 106 surrounding the opening when the multiple emitting portions 1015 are emitted. For example, the intensity (or amount) of light transmitted to the first region may be less than the intensity (or amount) of light transmitted to the second region.

Although not illustrated in FIG. 10B, each of the second sub pixels 140 may include an organic insulating layer including the light control material 160 and the other material 1092. For example, a thickness of the light control material 160 within the organic insulating layer within each of the second sub pixels 140 may be thinner than a thickness of the light control material 160 within the organic insulating layer 1060 within each of the first sub pixels 130. However, it is not limited thereto.

FIG. 11 is a block diagram illustrating an electronic device 1101 in a network environment 1100 according to various embodiments. Referring to FIG. 11, the electronic device 1101 in the network environment 1100 may communicate with an electronic device 1102 via a first network 1198 (e.g., a short-range wireless communication network), or at least one of an electronic device 1104 or a server 1108 via a second network 1199 (e.g., a long-range wireless communication network). According to an embodiment, the electronic device 1101 may communicate with the electronic device 1104 via the server 1108. According to an embodiment, the electronic device 1101 may include a processor 1120, memory 1130, an input module 1150, a sound output module 1155, a display module 1160, an audio module 1170, a sensor module 1176, an interface 1177, a connecting terminal 1178, a haptic module 1179, a camera module 1180, a power management module 1188, a battery 1189, a communication module 1190, a subscriber identification module(SIM) 1196, or an antenna module 1197. In some embodiments, at least one of the components (e.g., the connecting terminal 1178) may be omitted from the electronic device 1101, or one or more other components may be added in the electronic device 1101. In some embodiments, some of the components (e.g., the sensor module 1176, the camera module 1180, or the antenna module 1197) may be implemented as a single component (e.g., the display module 1160).

The processor 1120 may execute, for example, software (e.g., a program 1140) to control at least one other component (e.g., a hardware or software component) of the electronic device 1101 coupled with the processor 1120, and may perform various data processing or computation. According to an embodiment, as at least part of the data processing or computation, the processor 1120 may store a command or data received from another component (e.g., the sensor module 1176 or the communication module 1190) in volatile memory 1132, process the command or the data stored in the volatile memory 1132, and store resulting data in non-volatile memory 1134. According to an embodiment, the processor 1120 may include a main processor 1121 (e.g., a central processing unit (CPU) or an application processor (AP)), or an auxiliary processor 1123 (e.g., a graphics processing unit (GPU), a neural processing unit (NPU), an image signal processor (ISP), a sensor hub processor, or a communication processor (CP)) that is operable independently from, or in conjunction with, the main processor 1121. For example, when the electronic device 1101 includes the main processor 1121 and the auxiliary processor 1123, the auxiliary processor 1123 may be adapted to consume less power than the main processor 1121, or to be specific to a specified function. The auxiliary processor 1123 may be implemented as separate from, or as part of the main processor 1121.

The auxiliary processor 1123 may control at least some of functions or states related to at least one component (e.g., the display module 1160, the sensor module 1176, or the communication module 1190) among the components of the electronic device 1101, instead of the main processor 1121 while the main processor 1121 is in an inactive (e.g., sleep) state, or together with the main processor 1121 while the main processor 1121 is in an active state (e.g., executing an application). According to an embodiment, the auxiliary processor 1123 (e.g., an image signal processor or a communication processor) may be implemented as part of another component (e.g., the camera module 1180 or the communication module 1190) functionally related to the auxiliary processor 1123. According to an embodiment, the auxiliary processor 1123 (e.g., the neural processing unit) may include a hardware structure specified for artificial intelligence model processing. An artificial intelligence model may be generated by machine learning. Such learning may be performed, e.g., by the electronic device 1101 where the artificial intelligence is performed or via a separate server (e.g., the server 1108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1130 may store various data used by at least one component (e.g., the processor 1120 or the sensor module 1176) of the electronic device 1101. The various data may include, for example, software (e.g., the program 1140) and input data or output data for a command related thereto. The memory 1130 may include the volatile memory 1132 or the non-volatile memory 1134.

The program 1140 may be stored in the memory 1130 as software, and may include, for example, an operating system (OS) 1142, middleware 1144, or an application 1146.

The input module 1150 may receive a command or data to be used by another component (e.g., the processor 1120) of the electronic device 1101, from the outside (e.g., a user) of the electronic device 1101. The input module 1150 may include, for example, a microphone, a mouse, a keyboard, a key (e.g., a button), or a digital pen (e.g., a stylus pen).

The sound output module 1155 may output sound signals to the outside of the electronic device 1101. The sound output module 1155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1160 may visually provide information to the outside (e.g., a user) of the electronic device 1101. The display module 1160 may include, for example, a display, a hologram device, or a projector and control circuitry to control a corresponding one of the display, hologram device, and projector. According to an embodiment, the display module 1160 may include a touch sensor adapted to detect a touch, or a pressure sensor adapted to measure the intensity of force incurred by the touch.

The audio module 1170 may convert a sound into an electrical signal and vice versa. According to an embodiment, the audio module 1170 may obtain the sound via the input module 1150, or output the sound via the sound output module 1155 or a headphone of an external electronic device (e.g., an electronic device 1102) directly (e.g., wiredly) or wirelessly coupled with the electronic device 1101.

The sensor module 1176 may detect an operational state (e.g., power or temperature) of the electronic device 1101 or an environmental state (e.g., a state of a user) external to the electronic device 1101, and then generate an electrical signal or data value corresponding to the detected state. According to an embodiment, the sensor module 1176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1177 may support one or more specified protocols to be used for the electronic device 1101 to be coupled with the external electronic device (e.g., the electronic device 1102) directly (e.g., wiredly) or wirelessly. According to an embodiment, the interface 1177 may include, for example, a high definition multimedia interface (HDMI), a universal serial bus (USB) interface, a secure digital (SD) card interface, or an audio interface.

A connecting terminal 1178 may include a connector via which the electronic device 1101 may be physically connected with the external electronic device (e.g., the electronic device 1102). According to an embodiment, the connecting terminal 1178 may include, for example, an HDMI connector, a USB connector, a SD card connector, or an audio connector (e.g., a headphone connector).

The haptic module 1179 may convert an electrical signal into a mechanical stimulus (e.g., a vibration or a movement) or electrical stimulus which may be recognized by a user via his tactile sensation or kinesthetic sensation. According to an embodiment, the haptic module 1179 may include, for example, a motor, a piezoelectric element, or an electric stimulator.

The camera module 1180 may capture a still image or moving images. According to an embodiment, the camera module 1180 may include one or more lenses, image sensors, image signal processors, or flashes.

The power management module 1188 may manage power supplied to the electronic device 1101. According to an embodiment, the power management module 1188 may be implemented as at least part of, for example, a power management integrated circuit (PMIC).

The battery 1189 may supply power to at least one component of the electronic device 1101. According to an embodiment, the battery 1189 may include, for example, a primary cell which is not rechargeable, a secondary cell which is rechargeable, or a fuel cell.

The communication module 1190 may support establishing a direct (e.g., wired) communication channel or a wireless communication channel between the electronic device 1101 and the external electronic device (e.g., the electronic device 1102, the electronic device 1104, or the server 1108) and performing communication via the established communication channel. The communication module 1190 may include one or more communication processors that are operable independently from the processor 1120 (e.g., the application processor (AP)) and supports a direct (e.g., wired) communication or a wireless communication. According to an embodiment, the communication module 1190 may include a wireless communication module 1192 (e.g., a cellular communication module, a short-range wireless communication module, or a global navigation satellite system (GNSS) communication module) or a wired communication module 1194 (e.g., a local area network (LAN) communication module or a power line communication (PLC) module). A corresponding one of these communication modules may communicate with the external electronic device via the first network 1198 (e.g., a short-range communication network, such as Bluetooth^{™}, wireless-fidelity (Wi-Fi) direct, or infrared data association (IrDA)) or the second network 1199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1192 may identify and authenticate the electronic device 1101 in a communication network, such as the first network 1198 or the second network 1199, using subscriber information (e.g., international mobile subscriber identity (IMSI)) stored in the subscriber identification module 1196.

The wireless communication module 1192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1192 may support a high-frequency band (e.g., the mmWave band) to achieve, e.g., a high data transmission rate. The wireless communication module 1192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1192 may support various requirements specified in the electronic device 1101, an external electronic device (e.g., the electronic device 1104), or a network system (e.g., the second network 1199). According to an embodiment, the wireless communication module 1192 may support a peak data rate (e.g., 20Gbps or more) for implementing eMBB, loss coverage (e.g., 1164dB or less) for implementing mMTC, or U-plane latency (e.g., 0.5ms or less for each of downlink (DL) and uplink (UL), or a round trip of 11ms or less) for implementing URLLC.

The antenna module 1197 may transmit or receive a signal or power to or from the outside (e.g., the external electronic device) of the electronic device 1101. According to an embodiment, the antenna module 1197 may include an antenna including a radiating element composed of a conductive material or a conductive pattern formed in or on a substrate (e.g., a printed circuit board (PCB)). According to an embodiment, the antenna module 1197 may include a plurality of antennas (e.g., array antennas). In such a case, at least one antenna appropriate for a communication scheme used in the communication network, such as the first network 1198 or the second network 1199, may be selected, for example, by the communication module 1190 (e.g., the wireless communication module 1192) from the plurality of antennas. The signal or the power may then be transmitted or received between the communication module 1190 and the external electronic device via the selected at least one antenna. According to an embodiment, another component (e.g., a radio frequency integrated circuit (RFIC)) other than the radiating element may be additionally formed as part of the antenna module 1197.

According to various embodiments, the antenna module 1197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1101 and the external electronic device 1104 via the server 1108 coupled with the second network 1199. Each of the electronic devices 1102 or 1104 may be a device of a same type as, or a different type, from the electronic device 1101. According to an embodiment, all or some of operations to be executed at the electronic device 1101 may be executed at one or more of the external electronic devices 1102, 1104, or 1108. For example, if the electronic device 1101 should perform a function or a service automatically, or in response to a request from a user or another device, the electronic device 1101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1101. The electronic device 1101 may provide the outcome, with or without further processing of the outcome, as at least part of a reply to the request. To that end, a cloud computing, distributed computing, mobile edge computing (MEC), or client-server computing technology may be used, for example. The electronic device 1101 may provide ultra low-latency services using, e.g., distributed computing or mobile edge computing. In another embodiment, the external electronic device 1104 may include an internet-of-things (IoT) device. The server 1108 may be an intelligent server using machine learning and/or a neural network. According to an embodiment, the external electronic device 1104 or the server 1108 may be included in the second network 1199. The electronic device 1101 may be applied to intelligent services (e.g., smart home, smart city, smart car, or healthcare) based on 5G communication technology or IoT-related technology.

FIG. 12 is a block diagram 1200 illustrating the display module 1160 according to various embodiments. Referring to FIG. 12, the display module 1160 may include a display 1210 and a display driver integrated circuit (DDI) 1230 to control the display 1210. The DDI 1230 may include an interface module 1231, memory 1233 (e.g., buffer memory), an image processing module 1235, or a mapping module 1237. The DDI 1230 may receive image information that contains image data or an image control signal corresponding to a command to control the image data from another component of the electronic device 1101 via the interface module 1231. For example, according to an embodiment, the image information may be received from the processor 1120 (e.g., the main processor 1121 (e.g., an application processor)) or the auxiliary processor 1123 (e.g., a graphics processing unit) operated independently from the function of the main processor 1121. The DDI 1230 may communicate, for example, with touch circuitry 1250 or the sensor module 1176 via the interface module 1231. The DDI 1230 may also store at least part of the received image information in the memory 1233, for example, on a frame by frame basis. The image processing module 1235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 1210. The mapping module 1237 may generate a voltage value or a current value corresponding to the image data pre-processed or post-processed by the image processing module 1235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 1210 may be driven, for example, based at least in part on the voltage value or the current value such that visual information (e.g., a text, an image, or an icon) corresponding to the image data may be displayed via the display 1210.

According to an embodiment, the display module 1160 may further include the touch circuitry 1250. The touch circuitry 1250 may include a touch sensor 1251 and a touch sensor IC 1253 to control the touch sensor 1251. The touch sensor IC 1253 may control the touch sensor 1251 to sense a touch input or a hovering input with respect to a certain position on the display 1210. To achieve this, for example, the touch sensor 1251 may detect (e.g., measure) a change in a signal (e.g., a voltage, a quantity of light, a resistance, or a quantity of one or more electric charges) corresponding to the certain position on the display 1210. The touch circuitry 1250 may provide input information (e.g., a position, an area, a pressure, or a time) indicative of the touch input or the hovering input detected via the touch sensor 1251 to the processor 1120. According to an embodiment, at least part (e.g., the touch sensor IC 1253) of the touch circuitry 1250 may be formed as part of the display 1210 or the DDI 1230, or as part of another component (e.g., the auxiliary processor 1123) disposed outside the display module 1160.

According to an embodiment, the display module 1160 may further include at least one sensor (e.g., a fingerprint sensor, an iris sensor, a pressure sensor, or an illuminance sensor) of the sensor module 1176 or a control circuit for the at least one sensor. In such a case, the at least one sensor or the control circuit for the at least one sensor may be embedded in one portion of a component (e.g., the display 1210, the DDI 1230, or the touch circuitry 1250)) of the display module 1160. For example, when the sensor module 1176 embedded in the display module 1160 includes a biometric sensor (e.g., a fingerprint sensor), the biometric sensor may obtain biometric information (e.g., a fingerprint image) corresponding to a touch input received via a portion of the display 1210. As another example, when the sensor module 1176 embedded in the display module 1160 includes a pressure sensor, the pressure sensor may obtain pressure information corresponding to a touch input received via a partial or whole area of the display 1210. According to an embodiment, the touch sensor 1251 or the sensor module 1176 may be disposed between pixels in a pixel layer of the display 1210, or over or under the pixel layer.

As described above, an electronic device 1001 may comprise a display panel 100 including pixels of a first set 110 and pixels of a second set 120 between the pixels of the first set 110, wherein each of the pixels of the first set 110 includes first sub pixels 130, and each of the pixels of the second set 120 of pixels includes second sub pixels 140. According to an embodiment, each of the first sub pixels 130 may include a first emitting layer 210 including a single emitting portion 215 for providing a first viewing angle, and a first encapsulation layer 220 on the first emitting layer 210.

According to an embodiment, each of the second sub pixels 140 may include a second emitting layer 310 including multiple emitting portions 315 each having an area narrower than an area of the single emitting portion 215, for providing a second viewing angle narrower than the first viewing angle, and a second encapsulation layer 320 on the second emitting layer 310. According to an embodiment, the first encapsulation layer 220 among the first encapsulation layer 220 and the second encapsulation layer 320 may include a groove 291, positioned on the single emitting portion 215, in a second surface 293 opposite to a first surface 292 contacted on the first emitting layer 210. According to an embodiment, each of the first sub pixels 130 may include a light control material 160, filling the groove 291, having a second refractive index different from a first refractive index of the first encapsulation layer 220.

According to an embodiment, the second surface 293 may include a first portion including the groove 291 and a second portion surrounding the first portion. According to an embodiment, a first region 811 on the light control material 160 may be darker than a second region 812 on the second portion, when the single emitting portion 215 is emitted.

According to an embodiment, an area of the light control material 160 may be narrower than an area of the single emitting portion 215, when viewing the second surface 293 in a direction opposite to a direction in which the second surface 293 faces.

According to an embodiment, the electronic device 1001 may comprise display driver circuitry 190 operatively coupled to the display panel 100. According to an embodiment, the display driver circuitry 190 may be configured to, while a second mode is provided among a first mode and the second mode reducing light transmitted to a second space around a first surface on the display panel 100 relative to the first mode, drive at least a portion of the pixels of the first set 110 and the pixels of the second set 120, for displaying of an image. According to an embodiment, at least the portion of the pixels of the first set 110 may be driven to reduce a contrast ratio of the image, while the second mode is provided.

According to an embodiment, each of the groove 291 and the light control material 160 may include a surface having a convex shape toward the single emitting portion 215.

According to an embodiment, the display panel 100 may include a center region 710 and an edge region 720 surrounding the center region 710. According to an embodiment, a relative position between the light control material 160 in a sub pixel in a pixel 701 in the center region 710 among the pixels of the first set 110 and the single emitting portion 215 may be different from a relative position between the light control material 160 in a sub pixel in a pixel 702, 703 in the edge region 720 among the pixels of the first set 110 and the single emitting portion 215.

According to an embodiment, the light control material 160 may form a layer 602 on the first encapsulation layer 220.

According to an embodiment, the light control material 160 may be translucent.

According to an embodiment, each of the first sub pixels 130 may include a pixel definition layer (PDL) 205 of each of the first sub pixels 130 disposed along a boundary of the single emitting portion 215. According to an embodiment, each of the second sub pixels 140 may include a PDL 305 of each of the second sub pixels 140 disposed along a boundary of a first emitting portion 311 of the multiple emitting portions 315 and a boundary of a second emitting portion 312 of the multiple emitting portions 315.

According to an embodiment, the first emitting layer 210 may include a first electrode layer 203 on a thin-film transistor (TFT) 201 in a substrate of each of the first sub pixels 130. According to an embodiment, the first emitting layer 210 may include a second electrode layer 209 on the first electrode layer 203. According to an embodiment, the first emitting layer 210 may include the single emitting portion 215 between the first electrode layer 203 and the second electrode layer 209. According to an embodiment, the second emitting layer 310 may include a first electrode layer 303 of each of the second sub pixels 140 on a TFT 301 in a substrate of each of the second sub pixels 140. According to an embodiment, the second emitting layer 310 may include a second electrode layer 309 of each of the second sub pixels 140 on the first electrode layer 303 of each of the second sub pixels 140. According to an embodiment, the second emitting layer 310 may include the multiple light emitting portions 315 between the first electrode layer 303 of each of the second sub pixels 140 and the second electrode layer 309 of each of the second sub pixels 140.

According to an embodiment, each of the first sub pixels 130 may include at least one layer on the first encapsulation layer 220. According to an embodiment, each of the second sub pixels 140 may include at least one layer including a light blocking member on the second encapsulation layer 320 that surrounds each of the multiple emitting portions 315, when viewing the second sub pixels 140 in a direction opposite to a direction in which the second sub pixels 140 faces.

According to an embodiment, each of the first sub pixels 130 may include an opaque member 232 disposed along a boundary of each of the first sub pixels 130. According to an embodiment, the opaque member 232 of each of the first sub pixels 130 may be included in the at least one layer on the first encapsulation layer 220.

According to an embodiment, the light control material 160 may be positioned at a center of the single emitting portion 215, when viewing the second surface 293 in a direction opposite to a direction in which the second surface 293 faces.

According to an embodiment, a shape of the light control material 160 may be a circle when viewing the second surface 293 in a direction opposite to a direction in which the second surface 293 faces.

According to an embodiment, a shape of the light control material 160 may be a quadrangle when viewing the second surface 293 in a direction opposite to a direction in which the second surface 293 faces.

As described above, according to an embodiment, a display panel 100 may include pixels of a first set 110, wherein each of the pixels of the first set 110 includes first sub pixels 130. According to an embodiment, the display panel 100 may include pixels of a second set 120 between the pixels of the first set 110, wherein each of the pixels of the second set 120 of pixels includes second sub pixels 140. According to an embodiment, each of the first sub pixels 130 may include a first emitting layer 210 including a single emitting portion 215 for providing a first viewing angle, and a first encapsulation layer 220 on the first emitting layer 210. According to an embodiment, each of the second sub pixels 140 may include a second emitting layer 310 including multiple emitting portions 315 each having an area narrower than an area of the single emitting portion 215, for providing a second viewing angle narrower than the first viewing angle, and a second encapsulation layer 320 on the second emitting layer 310. According to an embodiment, the first encapsulation layer 220 among the first encapsulation layer 220 and the second encapsulation layer 320 may include a groove 291, positioned on the single emitting portion 215, in a second surface 293 opposite to a first surface 292 contacted on the first emitting layer 210. According to an embodiment, each of the first sub pixels 130 may include a light control material 160, filling the groove 291, having a second refractive index different from a first refractive index of the first encapsulation layer 220.

According to an embodiment, the second surface 293 may include a first portion including the groove 291 and a second portion surrounding the first portion. According to an embodiment, a first region 811 on the light control material 160 may be darker than a second region 812 on the second portion, when the single emitting portion 215 is emitted.

According to an embodiment, an area of the light control material 160 may be narrower than an area of the single emitting portion 215, when viewing the second surface 293 in a direction opposite to a direction in which the second surface 293 faces.

According to an embodiment, each of the groove 291 and the light control material 160 may include a surface having a convex shape toward the single emitting portion 215.

According to an embodiment, the display panel 100 may include a center region 710 and an edge region 720 surrounding the center region 710. According to an embodiment, a relative position between the light control material 160 in a sub pixel in a pixel 701 in the center region 710 among the pixels of the first set 110 and the single emitting portion 215 may be different from a relative position between the light control material 160 in a sub pixel in a pixel 702, 703 in the edge region 720 among the pixels of the first set 110 and the single emitting portion 215.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "coupled to," "connected with," or "connected towith" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1140) including one or more instructions that are stored in a storage medium (e.g., internal memory 1136 or external memory 1138) that is readable by a machine (e.g., the electronic device 1101). For example, a processor (e.g., the processor 1120) of the machine (e.g., the electronic device 1101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which where data is semi-permanently stored in the storage medium and where a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (1001) comprising:
a display panel (100) including:
pixels of a first set (110), wherein each of the pixels of the first set (110) includes first sub pixels (130), and
pixels of a second set (120) between the pixels of the first set (110), wherein each of the pixels of the second set (120) of pixels includes second sub pixels (140),
wherein each of the first sub pixels (130) includes:
a first emitting layer (210) including a single emitting portion (215) for providing a first viewing angle, and
a first encapsulation layer (220) on the first emitting layer (210),
wherein each of the second sub pixels (140) includes:
a second emitting layer (310) including multiple emitting portions (315) each having an area narrower than an area of the single emitting portion (215), for providing a second viewing angle narrower than the first viewing angle, and
a second encapsulation layer (320) on the second emitting layer (310),
wherein the first encapsulation layer (220) among the first encapsulation layer (220) and the second encapsulation layer (320) includes a groove (291), positioned on the single emitting portion (215), in a second surface (293) opposite to a first surface (292) contacted on the first emitting layer (210), and
wherein each of the first sub pixels (130) further includes a light control material (160), filling the groove (291), having a second refractive index different from a first refractive index of the first encapsulation layer (220).

2. The electronic device (1001) of claim 1, wherein the second surface (293) includes a first portion including the groove (291) and a second portion surrounding the first portion, and
wherein a first region (811) on the light control material (160) is darker than a second region (812) on the second portion, when the single emitting portion (215) is emitted.

3. The electronic device (1001) of claim 1, wherein an area of the light control material (160) is narrower than an area of the single emitting portion (215), when viewing the second surface (293) in a direction opposite to a direction in which the second surface (293) faces.

4. The electronic device (1001) of claim 1, further comprising:
display driver circuitry (190) operatively coupled to the display panel (100),
wherein the display driver circuitry (190) is configured to:
while a second mode is provided among a first mode and the second mode reducing light transmitted to a second space around a first surface on the display panel (100) relative to the first mode, drive at least a portion of the pixels of the first set (110) and the pixels of the second set (120), for displaying of an image, and
wherein at least the portion of the pixels of the first set (110) is driven to reduce a contrast ratio of the image, while the second mode is provided.

5. The electronic device (1001) of claim 1, wherein each of the groove (291) and the light control material (160) includes a surface having a convex shape toward the single emitting portion (215).

6. The electronic device (1001) of claim 1, wherein the display panel (100) includes a center region (710) and an edge region (720) surrounding the center region (710), and
wherein a relative position between the light control material (160) in a sub pixel in a pixel (701) in the center region (710) among the pixels of the first set (110) and the single emitting portion (215) is different from a relative position between the light control material (160) in a sub pixel in a pixel (702, 703) in the edge region (720) among the pixels of the first set (110) and the single emitting portion (215).

7. The electronic device (1001) of claim 1, wherein the light control material (160) forms a layer (602) on the first encapsulation layer (220).

8. The electronic device (1001) of claim 1, wherein the light control material (160) is translucent.

9. The electronic device (1001) of claim 1, wherein each of the first sub pixels (130) includes a pixel definition layer, PDL, (205) of each of the first sub pixels (130) disposed along a boundary of the single emitting portion (215), and
wherein each of the second sub pixels (140) includes a PDL (305) of each of the second sub pixels (140) disposed along a boundary of a first emitting portion (311) of the multiple emitting portions (315) and a boundary of a second emitting portion (312) of the multiple emitting portions (315).

10. The electronic device (1001) of claim 9, wherein the first emitting layer (210) includes:
a first electrode layer (203) on a thin-film transistor, TFT, (201) in a substrate of each of the first sub pixels (130),
a second electrode layer (209) on the first electrode layer (203), and
the single emitting portion (215) between the first electrode layer (203) and the second electrode layer (209), and
wherein the second emitting layer (310) includes:
a first electrode layer (303) of each of the second sub pixels (140) on a TFT (301) in a substrate of each of the second sub pixels (140),
a second electrode layer (309) of each of the second sub pixels (140) on the first electrode layer (303) of each of the second sub pixels (140), and
the multiple light emitting portions (315) between the first electrode layer (303) of each of the second sub pixels (140) and the second electrode layer (309) of each of the second sub pixels (140).

11. The electronic device (1001) of claim 1, wherein each of the first sub pixels (130) includes at least one layer on the first encapsulation layer (220), and
wherein each of the second sub pixels (140) includes at least one layer including a light blocking member on the second encapsulation layer (320) that surrounds each of the multiple emitting portions (315), when viewing the second sub pixels (140) in a direction opposite to a direction in which the second sub pixels (140) faces.

12. The electronic device (1001) of claim 11, wherein each of the first sub pixels (130) includes an opaque member (232) disposed along a boundary of each of the first sub pixels (130), and
wherein the opaque member (232) of each of the first sub pixels (130) is included in the at least one layer on the first encapsulation layer (220).

13. The electronic device (1001) of claim 1, wherein the light control material (160) is positioned at a center of the single emitting portion (215), when viewing the second surface (293) in a direction opposite to a direction in which the second surface (293) faces.

14. The electronic device (1001) of claim 1, wherein a shape of the light control material (160) is a circle when viewing the second surface (293) in a direction opposite to a direction in which the second surface (293) faces.

15. The electronic device (1001) of claim 1, wherein a shape of the light control material (160) is a quadrangle when viewing the second surface (293) in a direction opposite to a direction in which the second surface (293) faces.
